# EUROPEAN PATENT APPLICATION

(11) **EP 1 885 002 A1**
(43) Date of publication of application: **06.02.2008**
(21) Application number: 06756460.9
(22) Date of filing: 23.05.2006
(51) Int. Cl.: H01L 33/00, H01S 5/183

(54) **NITRIDE SEMICONDUCTOR LIGHT EMITTING ELEMENT**

(30) Priority: 24.05.2005 JP 2005151511
(71) Applicant: ROHM CO., LTD., Kyoto-shi, Kyoto 615-8585 (JP)
(72) Inventor: Tanaka, Haruo, Shiga 5200503 (JP); Sonobe, Masayuki c/o Rohm Co., Ltd., Kyoto-shi, Kyoto; 6158585 (JP)
(74) Representative: TBK-Patent
(86) International application number: PCT/JP2006/310204
(87) International publication number: WO 2006/126516

(57) **Abstract**

There is provided a nitride semiconductor light emitting device capable of inhibiting output deterioration of light emission caused by quality deterioration of a nitride semiconductor layer due to lattice-mismatching between a substrate and the nitride semiconductor layer, and utilizing light traveling to the substrate efficiently, while forming a light emitting device of a vertical type which has one electrode on a back surface of the substrate by using the substrate made of SiC. A light reflecting layer (2) which is formed by laminating low refractive index layers (21) and high refractive index layers (22) having different refractive indices alternately is directly provided on the SiC substrate (1), and a semiconductor lamination portion (5) which is formed by laminating nitride semiconductor layers so as to form at least a light emitting layer forming portion (3) is provided on the light reflecting layer (2). An upper electrode (7) is provided on an upper surface side of the semiconductor lamination portion (5), and a lower electrode (8) is provided on a back surface of the SiC substrate (1).

## Description

### FIELD OF THE INVENTION

The present invention relates to a semiconductor light emitting device using nitride semiconductor. More particularly, the present invention relates to a nitride semiconductor light emitting device using a substrate made of SiC, capable of taking out light emitted in a light emitting layer forming portion efficiently while providing one electrode on a back surface of the substrate, and improving external quantum efficiency.

### BACKGROUND OF THE INVENTION

A conventional semiconductor light emitting device using nitride semiconductor is formed by growing a nitride semiconductor lamination portion including a buffer layer and a light emitting layer forming portion, for example, on a sapphire substrate, exposing a conductivity type layer of a lower layer side of the semiconductor lamination portion by etching a part of the semiconductor lamination portion, and providing a lower electrode on a surface of the exposed conductivity type layer of the lower layer side and an upper electrode at an upper surface side of the semiconductor lamination portion. When such a substrate made of sapphire is used, since sapphire is an insulating material, an electrode to be connected to a conductivity type layer of a lower layer side of a semiconductor lamination portion can not be formed on a back surface of the substrate, and, as described above, it is necessary to expose the conductivity type layer of the lower layer side of the semiconductor lamination portion by removing a part of the semiconductor lamination portion by etching. Therefore, a production process becomes very complicated, and, at the same time, there arise problems to electric characteristics, such as output deterioration of light emission, due to increasing of electric resistance at an electrode connecting portion, or the like, which is caused by contamination on a light emitting surface or an electrode forming surface during etching.

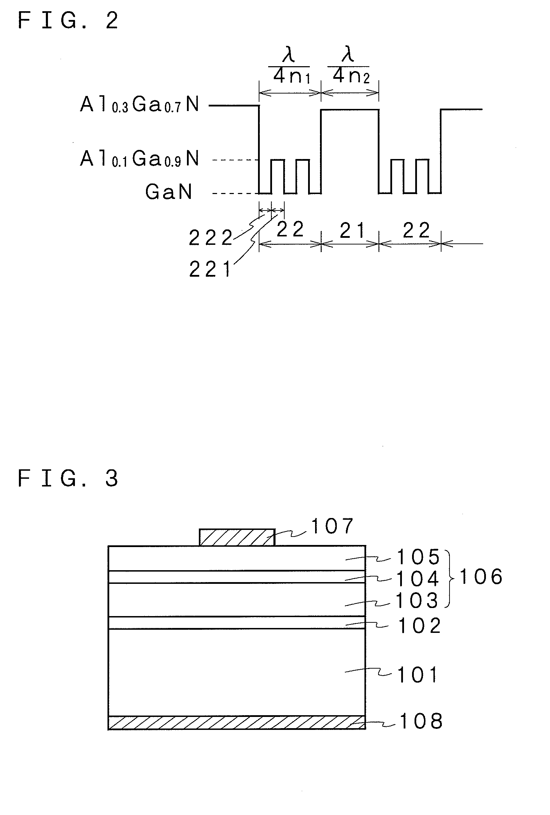

In order to solve such problems, there has been introduced a semiconductor light emitting device having a structure in which a semiconductor substrate made of SiC is used as a substrate, and a light emitting layer forming portion with a double heterojunction through a buffer layer is grown on the substrate by using nitride semiconductor. Namely, as shown in Fig. 3, a buffer layer 102 is provided on a SiC substrate 101, a light emitting layer forming portion 106 constituted of a double heterojunction with a sandwich structure, in which an active layer 104 is sandwiched by a lower semiconductor layer 103 and an upper semiconductor layer 105, is laminated thereon, and an upper electrode 107 is formed thereon and a lower electrode 108 is formed on a back surface of the SiC substrate 101, thereby, the lower electrode 108 to be connected to a lower conductivity type layer of the semiconductor lamination portion is formed on the back surface of the semiconductor substrate 101 without etching a part of the semiconductor lamination portion such as the light emitting layer forming portion 106 or the like (cf. for example PATENT DOCUMENT 1). PATENT DOCUMENT 1: US PATENT SPECIFICATION No. 5523589

### DISCLOSURE OF THE INVENTION

### PROBLEM TO BE SOLVED BY THE PRESENT INVENTION

It is preferable to use a substrate made of SiC as described above, because an electrode of one side can be formed on a back surface of the substrate without etching a part of the semiconductor lamination portion. However, perfect lattice matching with the nitride semiconductor layer can not be achieved even if the SiC substrate is used, then, there is a problem such that light emitting efficiency decreases when crystallinity of the nitride semiconductor layer laminated thereon is poor. In this case, it has been suggested, as described above, that a buffer layer 102 is interposed between the SiC substrate 101 and the light emitting layer forming portion 106, and it is preferable to interpose AlGaN based compound (which means that a mixed crystal ratio of Al and Ga can take various ratios without a definite ratio, and 'based' is used in the same meaning hereinafter) having a mixed crystal ratio of Al as large as possible as the buffer layer, because AlN among nitride semiconductor has a lattice constant nearest to that of SiC. However, the AlN makes an insulating layer and can not be conductive, and carrier concentration can not be enhanced with increasing Al concentration even in AlGaN based compound. Then, when an electrode of one side is formed on a back surface of the SiC substrate, it becomes necessary to increase carrier concentration of the buffer layer sufficiently from the view point of the carrier concentration, so a limitation of increasing the mixed crystal ratio of Al is approximately 0.2. Therefore, the lattice mismatching between the SiC substrate and the nitride semiconductor layer can not be alleviated sufficiently.

In addition, SiC absorbs the light emitted in the nitride semiconductor. Then, although, in case of a sapphire substrate, even the light traveling to the substrate side, it can be utilized by taking out from sides of the substrate or reflecting at a back surface of the substrate, there arises a problem such that light traveling to the substrate can be hardly utilized in case of using the SiC substrate. On the other hand, the light emitted in a light emitting layer is radiated all round, and the light with the same intensity as that of light traveling to an upper side of the semiconductor lamination portion where light is taken out travels to the SiC substrate side, and a problem occurs such that half of theoretical intensity of emitted light is wasted.

The present invention is directed to solve the above-described problems and an object of the present invention is to provide a nitride semiconductor light emitting device having a structure capable of raising external quantum efficiency by inhibiting output deterioration of light emission caused by quality deterioration of a nitride semiconductor layer due to lattice-mismatching between a substrate and a nitride semiconductor layer, and utilizing light traveling to the substrate side efficiently, while forming a light emitting device of a vertical type which has one electrode on a back surface of the substrate by using the substrate made of SiC.

Another object of the present invention is to provide a semiconductor light emitting device using nitride semiconductor, having a structure capable of carrying out lamination in a short time by avoiding changing temperature as much as possible during forming a lamination portion even if semiconductor lamination films as a reflecting layer are formed with a multilayer structure.

### MEANS FOR SOLVING THE PROBLEM

A nitride semiconductor light emitting device according to the present invention includes; a SiC substrate, a light reflecting layer provided directly on the SiC substrate by laminating low refractive index layers and high refractive index layers having different refractive indices alternately, a semiconductor lamination portion provided on the light reflecting layer by laminating nitride semiconductor layers so as to form at least a light emitting layer forming portion, and electrodes provided at an upper surface side of the semiconductor lamination portion and on a back surface of the SiC substrate, respectively.

Here, the nitride semiconductor means a compound of Ga of group III element and N of group V element or a nitride in which a part or all of Ga of group III element substituted by other element of group III element like Al, In or the like and/or a part of N of group V element substituted by other element of group V element like P, As or the like. And, the low refractive index and the high refractive index do not mean those absolute values, but means relative relationship between the refractive indices of both layers. In addition, a refractive index in case of forming a layer with a multilayer structure such as super lattice means an average refractive index thereof.

By forming the light reflecting layer with a lamination structure of AlₓGa₁₋ₓN (0 < x < 1) and Al_{y}Ga_{1-y}N (0 ≦ y < 1, y<x), a growth process of a multilayer film can be carried out in a short time and nitride semiconductor layers with excellent film quality can be laminated. Namely, when semiconductor layers each of which has a different refractive index are formed among AlGaN based compound, difference of the refractive index between both layers can not be made so large, but, on the contrary, when InGaN based compound is used for a high refractive index layer, growth thereof can not be carried out at a high temperature of approximately 700 °C or more which is for AlₓGa₁₋ₓN of a low refractive index layer. On the other hand, it is preferable to grow at a temperature as high as possible in order to form a multilayered structure with excellent crystallinity since a nitride semiconductor layer with excellent crystallinity is apt to be grown at a high temperature. Then, if InGaN based compound is used for a high refractive index layer, it takes a long time because a growth temperature should be varied every time for a low refractive index layer and for a high refractive index layer, and total crystallinity is lowered. However, a light reflecting layer excellent in film quality can be formed in a significantly short time by forming a lamination structure of AlₓGa₁₋ₓN (0 < x < 1) and Al_{y}Ga_{1-y}N (0 ≦ y < 1, y < x) because the growth can be carried out still at a high temperature by only varying concentration. A light reflecting property is remarkably improved by improving the film quality.

At least one of the low refractive index layer and the high refractive index layer of the light reflecting layer may be formed with a super lattice structure of adjustment layers and relaxation layers each of which has still different refractive index. And, for example, the adjustment layers may be made of InᵥGa₁₋ᵥN (0 ≦ v < 1) and the relaxation layers may be made of Al_{w}Ga_{1-w}N (0 < w < 1).

A second light reflecting layer may be provided on the light emitting layer forming portion, with a lamination structure of low refractive index layers and high refractive index layers. In this case, by laminating the light emitting layer forming portion so as to form a resonator in a vertical direction to a surface of the light emitting layer forming portion and taking out light from a part of the second light reflecting layer, a surface emitting laser may be formed.

By making the light emitting layer forming portion of AlₐGa_{b}In_{1-a-b}N (0≦ a≦ 1, 0≦ b≦ 1, 0≦ a+b≦ 1) and forming with a double hetero junction structure in which an active layer is sandwiched between an n-type layer and a p-type layer, carriers can be confined sufficiently and a semiconductor light emitting device with high light emitting efficiency can be obtained.

### EFFECT OF THE INVENTION

According to the present invention, since a light reflecting layer is formed with a multilayered film directly on a surface of the SiC substrate, film quality of nitride semiconductor layers laminated thereon is improved and even light traveling to the substrate side among light emitted in a light emitting layer becomes easy to be radiated from a surface side by being reflected by the light reflecting layer. As described above, the SiC substrate and nitride semiconductor are not matched with each other in a lattice constant or the like, and even if a buffer layer is interposed, the buffer layer can not always achieve a function of the buffer layer sufficiently because a mixed crystal ratio of Al can not be raised so high in order to keep conductivity of the buffer layer. However, since carrier concentration can be raised easily, and layers having a different lattice constant or the like can be laminated easily by making a buffer layer with a multilayer structure, a layer having a lattice constant near to that of the SiC substrate can be grown by raising the mixed crystal ratio of Al, and the film quality of nitride semiconductor layers grown thereon can be improved. In addition, the light traveling to the substrate side can be reflected by laminating the multilayered film with a thickness which makes the multilayered film a reflecting layer of light emitted in a light emitting layer, and almost all emitted light can be taken out to a surface side. As a result, external quantum efficiency can be remarkably improved and a nitride semiconductor light emitting device with excellent light emitting efficiency can be obtained.

As described above, by forming a light reflecting layer with a lamination structure of AlₓGa₁₋ₓN (0 < x < 1) and Al_{y}Ga_{1-y}N (0 ≦ y < 1, y < x), the light reflecting layer can be grown only at a temperature of approximately 700 °C or more, thereby nitride semiconductor layers especially excellent in crystallinitty can be laminated. And, at the same time, although in case of interposing InGaN based compound, a layer thereof should be grown at a low temperature of approximately 600 °C or less, and raising and lowering temperature should be repeated in order to form a multilayered film, the multilayered film can be grown very easily because repetition of raising and lowering temperature is not necessary. In addition, in a nitride semiconductor layer, a semiconductor layer with more excellent film quality can be obtained when grown at a higher temperature, then the nitride semiconductor layer with further excellent film quality can be obtained.

### BRIEF DESCRIPTION OF THE DRAWINGS

Fig. 1 is an explanatory cross-sectional view of the nitride semiconductor light emitting device according to the present invention and an explanatory figure of an energy band figure.
Fig. 2 is an energy band figure showing another example of the light reflecting layer of Fig. 1.
Fig. 3 is an explanatory cross-sectional view showing an example of a nitride semiconductor light emitting device by the prior art.

### EXPLANATION OF LTTERS AND NUMERALS

1: SiC substrate
2: light reflecting layer
3: light emitting layer forming portion
4: contact layer
5: semiconductor lamination portion
7: upper electrode
8: lower electrode
21: low refractive index layer
22: high refractive index layer
31: n-type layer
32: active layer
33: p-type layer

### THE BEST EMBODIMENT OF THE PRESENT INVENTION

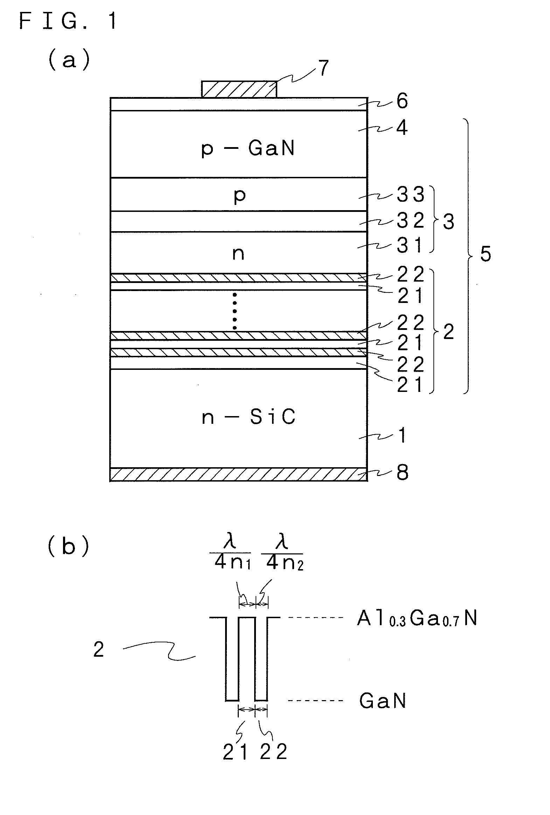

An explanation will be given below of a nitride semiconductor light emitting device according to the present invention in reference to the drawings. As an explanatory cross-sectional view of an embodiment and a figure of an energy band figure of the light reflecting layer are shown in Fig. 1, the nitride semiconductor light emitting device according to the present invention is formed such that a light reflecting layer 2 which is formed by laminating low refractive index layers 21 and high refractive index layers 22 having different refractive indices alternately is directly provided on a SiC substrate 1, and a semiconductor lamination portion 5 which is formed by laminating nitride semiconductor layers so as to form at least a light emitting layer forming portion 3 is provided on the light reflecting layer 2. And an upper electrode 7 is provided on an upper surface side of the semiconductor lamination portion 5, and a lower electrode 8 is provided on a back surface of the SiC substrate 1.

The SiC substrate 1 is made with a silicon carbide substrate of single crystal, and formed so as to have an n-type conductivity in an example shown in Fig. 1. The light reflecting layer 2 is laminated directly on the substrate 1. The light reflecting layer 2 is formed by laminating alternately the low refractive index layer 21 made of, for example, n-type AlₓGa₁₋ₓN (0<x<1, for example x=0.3) and the high refractive index layer 22 made of n-type Al_{y}Ga_{1-y}N (0 ≦ y < 1, y < x, for example y=0), with a thickness of λ /(4n₁) and λ /(4n₂) respectively (here, λ represents a wavelength of emitted light, and n₁ and n₂ represent refractive indices of the low refractive index layer and the high refractive index layer respectively), both of which have the same conductivity type as that of the substrate 1. In such manner, a distributed Bragg reflection (DBR) layer is formed by laminating layers having different refractive indices alternately, and light is reflected most especially by forming each layer with a thickness of λ /(4n).

It is preferable that the light reflecting layer 2 is formed with a lamination structure of, for example, the low refractive index layer 21 made of AlₓGa₁₋ₓN (0 < x < 1, for example x=0.3) and the high refractive index layer 22 made of AlyGa_{1-y}N (0 ≦ y < 1, y < x, for example y=0), because the both layers can be grown at a high temperature of approximately 700 to 1200 °C, and nitride semiconductor layers with excellent crystallinity can be laminated at a high temperature and are grown without varying a temperature even in case of laminating the both layers alternately. In this case, as it is difficult to make large difference of refractive indices between the both layers, it is required to increase number of layers, or to raise a mixed crystal ratio of Al of the low refractive index layer 21 in order to raise a reflection coefficient. Even when the mixed crystal ratio of Al is large, since the reflecting layer is formed not with a thick bulk layer as for a common buffer layer but with a lamination structure with GaN layers, carrier concentration can be raised and a film with excellent quality can be easily formed because the lattice constant approaches to that of the SiC substrate.

A high refractive index layer 22 made of In_{z}Ga_{1-z}N (0 < z < 1) may be used as the high refractive index layer 22, when the difference of refractive indices is made still large not by raising a mixed crystal ratio of Al high, or by raising the mixed crystal ratio of Al of a low refractive index layer. In this case, the AlGaN based compound is grown at the high temperature described above and the InGaN based compound at a low temperature of approximately 400 to 600 °C.

In addition, as the energy band figure is shown in Fig. 2, any layer or both layers of the low refractive index layer 21 or the high refractive index layer 22 described above may be formed not with a bulk layer but with a super lattice structure of layers with still different refractive indices such as adjustment layers 222 made of, for example, InᵥGa₁₋ᵥN (0**≦**v<1, for example v=0) and relaxation layers 221 made of, for example, Al_{w}Ga_{1-w}N (0 < w < 1, for example w=0.1), thereby the layer with the super lattice structure can inhibit occurrence of crystal defects due to difference of lattice constants or the like caused by the super lattice structure while contributing as a light reflecting layer, if layers having a low average refractive index of each super lattice structure and a high one are laminated alternately. And, both of the low refractive index layer 21 and the high refractive index layer 22 are not limited to the above-described example, and may be laminated with layers having different refractive indices so as to reflect light easily.

A light emitting layer forming portion 3 is formed directly or through other semiconductor layer on the light reflecting layer 2, in an example shown in Fig. 1, with a double heterojunction structure in which an n-type layer 31 made of n-type GaN or the like having a thickness of, for example, approximately 0.5 µm and a p-type layer 33 made of p-type GaN or the like having a thickness of, for example, approximately 0.5 µm are provided so as to sandwich an active layer 32, by using nitride material represented by a general equation AlₐGa_{b}In_{1-a-b}N (0 ≦ a ≦ 1, 0 ≦ b ≦ 1, 0 ≦ a+b ≦ 1). For example, in case of emitting blue light with a wavelength of 440 to 470 nm, the active layer 32 is formed with a bulk structure made of In_{0.15}Ga_{0.85}N having a thickness of approximately 0.01 to 0.1 µm, or with a single or multiple quantum well structure of a well layer made of In_{0.1}Ga_{0.9}N having a thickness of approximately 1 to 10 nm and a burrier layer made of GaN having a thickness of approximately 1 to 10 nm, total thickness of which is approximately 0.01 to 0.1 µm, by selecting material having a band gap energy in conformity with a wavelength of light emitted. The light emitting layer forming portion 3 is not limited to a double heterojunction structure and a single heterojunction structure or a pn junction formed by a homogeneous junction may be used. It is a point that semiconductor layers are laminated so as to form a light emitting portion where light is emitted by recombination of electrons and holes.

Although the active layer 32 is formed normally undoped, a p-type layer or n-type layer may be used. Since the n-type layer 31 and the p-type layer 33 are preferably formed of material having larger band gap energy than that of the active layer 32 from the view point of confinement of carriers, AlGaN based compound may be used instead of the above-described GaN, a multilayer structure with a layer having other composition may be used, furthermore, the n-type layer 31 and the p-type layer 32 may be formed with different compositions, and these are not to be limited to.

In case of using the light emitting layer forming portion 3 as a resonator of a vertical direction, for example, as in a surface emitting laser, it is preferable that a total thickness is adjusted to λ /n because the resonator is easily formed. In this case, the thickness is adjusted by a thickness of the n-type layer 31 and the p-type layer 33. In addition, in case of forming a resonator of a vertical direction, a second light reflecting layer, not shown in the figure, having a lamination structure of a low refractive index layer and a high refractive index layer is formed on the light emitting layer forming portion 3. In this meaning, composition or a thickness of the n-type layer 31 and the p-type layer 33 is adjusted properly such that the layers exhibit functions of a spacer layer, an electron barrier layer, a hole barrier layer or the like.

A contact layer 4 made of, for example, p-type GaN is formed on the light emitting layer forming portion 3, thereby a semiconductor lamination portion 5 is formed with the light reflecting layer 2, the light emitting layer forming portion 3 and the contact layer 4, described above. The contact layer 4 is provided in order to improve ohmic contact with an electrode provided thereon and diffuse electric current from an upper electrode 7 to whole part of a light emitting device chip, however, a light transmitting conductive layer may be provided directly on a surface of the light emitting layer forming portion 3. When the contact layer 4 is provided, since it is preferable to raise carrier concentration from the above-described object, GaN is generally used, however, AlGaN based compound or InGaN based compound may be used.

A light transmitting conductive layer 6 is formed, on the contact layer 4, with a Ni-Au alloy layer in a thickness of approximately 2 to 100 nm, or with a ZnO layer or an ITO layer in a thickness of approximately 0.1 to 2 µ m. The ZnO layer or the ITO layer is transmissive even if it is formed thick, but the Ni-Au alloy layer is formed thin because its transmissivity is lost when formed thick. In an example shown in Fig. 1, the ZnO layer is formed in a thickness of approximately 0.3 µm. The light transmitting conductive layer 6 is provided to solve problems such that electric current can be hardly diffused to whole surface of a chip because carrier concentration can not be easily raised in a nitride semiconductor layer, especially a p-type nitride semiconductor layer, and that it is difficult to get ohmic contact with an upper electrode 7 made with a metal film which is an electrode pad. However, the light transmitting conductive layer 6 may not be necessary if such problems can be solved.

In an example shown in Fig. 1, the upper electrode 7 is formed as a p-side electrode because an upper side of the semiconductor lamination portion 5 is a p-type layer, and formed with a lamination structure of, for example, Ti/Au, Pd/Au, Ni-Au or the like, in a thickness of approximately 0.1 to 1 µ m in total. In addition, a lower electrode (n-side electrode) 8 is formed on a back surface of the SiC substrate 1 with a lamination structure of Ti-Al alloy or Ti/Au, or the like in a thickness of approximately 0.1 to 1 µm in total.

Se, Si, Ge, or Te is mixed in reactive gas as impurity raw gas such as H₂Se, SiH₄, GeH₄, TeH₄ or the like in order to form the semiconductor lamination portion 5 in an n-type conductivity, and Mg or Zn is mixed in raw gas as metal organic gas such as biscyclopentadienyl magnesium (Cp₂Mg) or dimethyl zinc (DMZn) in order to form in a p-type conductivity. However, since an n-type conductivity layer is easily formed even without mixing impurities because N is apt to evaporate during forming layers, the property thereof may be utilized in case of forming the n-type conductivity layer.

Subsequently, a brief explanation of a method for manufacturing the nitride semiconductor light emitting device according to the present invention will be given below using a concrete example. The light reflecting layer 2 is formed by setting the SiC substrate 1 within, for example, a MOCVD (metal organic compound vapor deposition) apparatus, supplying component gas of a semiconductor layer grown such as trimethyl gallium, trimethyl aluminium, trimethyl indium or ammonia, any of H₂Se, SiH₄, GeH₄, or TeH₄ as n-type dopant gas, and necessary gas of DMZn or Cp₂Mg as p-type dopant gas, together with H₂ gas or N₂ gas as carrier gas, and laminating alternately the low refractive index layer 21 made of n-type Al_{0.3}Ga_{0.7} and the high refractive index layer 22 made of GaN, at a temperature of, for example approximately 700 to 1200 °C.

Then, the light emitting layer forming portion 3 is grown by laminating the n-type layer 31 made of GaN having a thickness of approximately 0.5 µm, a quantum well active layer 32 formed by laminating approximately 5 times of a well layer made of In_{0.1}Ga_{0.9}N and a burrier layer made of GaN alternately, and the p-type layer 33 made of GaN having a thickness of approximately 0.5 µ m, in order. The semiconductor lamination portion 5 is formed by growing epitaxially the p-type contact layer 4 made of p-type GaN having a thickness of approximately 0.05 to 2 µ m successively.

Thereafter, after providing a SiO₂ protecting film on a whole surface of the contact layer 4, activating the contact layer 4 and the p-type layer 33 are carried out by annealing at a temperature of approximately 400 to 800 °C for approximately 20 to 60 minutes. After finishing annealing, a wafer is set within a sputtering apparatus or a vacuum evaporation apparatus, the light transmitting conductive layer 6 made of ZnO is formed in a thickness of approximately 0.3 µm, further the upper electrode 7 is formed by forming a film made of Ti and Au or the like. Then, the SiC substrate 1 is thinned by lapping a back surface of the SiC substrate 1, and the lower electrode 8 is formed on the back surface of the substrate 1 by forming metal films made of such as Ti and Au or the like in the same manner. A chip of the nitride semiconductor light emitting device can be obtained by scribing the wafer into chips finally.

According to the present invention, since the SiC substrate is used in order to laminate semiconductor layers, the SiC substrate can be formed to have the same conductivity type as a conductivity type of a lower layer of semiconductor layers laminated. As a result, the lower electrode which is connected to the conductivity type layer of the lower layer of semiconductor layers laminated can be formed on a back surface of the substrate, thereby, it is not necessary to expose the conductivity type layer of the lower layer by etching. Then, electrodes can be formed easily without undesirable influence of contamination caused by etching a part of the semiconductor lamination portion.

Furthermore, since a light reflecting layer is provided directly on the surface of the SiC substrate, light emitted in the light emitting layer forming portion and traveling to the substrate side is not absorbed by the SiC substrate, and radiated from the surface side by being reflected to the surface side, together with light traveling to the surface side. As a result, external quantum efficiency is significantly improved and a nitride semiconductor light emitting device with remarkably high luminance can be obtained. Besides, since the light reflecting layer is formed by laminating layers having different refractive indices alternately each of which has a thickness of approximately λ /(4n), even in a layer having a high mixed crystal ratio of Al of, for example, AlGaN based compound, carrier concentration can be raised comparatively, and AlGaN based compound layer having a lattice constant near that of the SiC substrate can be grown. As a result, lattice mismatching between the SiC substrate and the GaN layer or the like can be alleviated and nitride semiconductor layers with more excellent crysatallinity can be grown.

As described above, according to the present invention, the nitride semiconductor light emitting device of the vertical type in which the electrode of one side is formed on the back surface of the substrate can be obtained with easy manufacturing process, and can be utilized with ease, and at the same time, the nitride semiconductor light emitting device with remarkably high luminance can be obtained since external quantum efficiency is improved significantly because light emitting efficiency is improved by improving crystallinity of nitride semiconductor layers and light traveling to the substrate side can be utilized by being reflected to the surface side.

Although the substrate has the n-type conductivity and the semiconductor layer of the lower layer has the n-type conductivity in the example described above, the substrate may have a p-type conductivity and the semiconductor layer of the lower layer may have the p-type conductivity. And, although the light emitting layer forming portion is formed in a double heterojunction structure in which the active layer is sandwiched by the n-type layer and the p-type layer, other semiconductor layer may be interposed between any layers, or a single heterojunction structure or a homogeneous pn junction may be used.

### INDUSTRIAL APPLICABILITY

According to the present invention, a semiconductor light emitting device using nitride semiconductor emitting blue light or ultraviolet light can be obtained, and a white light emitting device can be also obtained by coating fluorescent material converting light color, or the like. And they can be used for white light sources, light sources or pilot lamps for electrical appliances of wide range such as for lighting or the like, lighting apparatus, disinfection apparatus, or the like.

## Claims

1. A nitride semiconductor light emitting device comprising:
a SiC substrate;
a light reflecting layer provided directly on the SiC substrate by laminating low refractive index layers and high refractive index layers having different refractive indices alternately;
a semiconductor lamination portion provided on the light reflecting layer by laminating nitride semiconductor layers so as to form at least a light emitting layer forming portion; and
electrodes provided at an upper surface side of the semiconductor lamination portion and on a back surface of the SiC substrate, respectively.

2. The nitride semiconductor light emitting device according to claim 1, wherein the light reflecting layer is formed with a lamination structure of AlₓGa₁₋ₓN (0<x<1) and Al_{y}Ga_{1-y}N (0≦y<1, y<x).

3. The nitride semiconductor light emitting device according to claim 1, wherein at least one of the low refractive index layer and the high refractive index layer of the light reflecting layer is formed with a super lattice structure of adjustment layers and relaxation layers, each of the adjustment layers and each of the relaxation layers having still different refractive index.

4. The nitride semiconductor light emitting device according to claim 3, wherein the adjustment layer is made of InᵥGa₁₋ᵥN (0 ≦ v < 1) and the relaxation layer is made of Al_{w}Ga_{1-w}N (0<w<1).

5. The nitride semiconductor light emitting device according to claim 1, wherein a second light reflecting layer is provided on the light emitting layer forming portion, with a lamination structure of low refractive index layers and high refractive index layers.

6. The nitride semiconductor light emitting device according to claim 5, wherein the light emitting layer forming portion is laminated so as to form a resonator in a vertical direction to a surface of the light emitting layer forming portion and light is taken out from a part of the second light reflecting layer, thereby a surface emitting laser being formed.

7. The nitride semiconductor light emitting device according to claim 1, wherein the light emitting layer forming portion is made of AlₐGa_{b}In_{1-a-b}N (0≦ a≦ 1, 0≦ b≦ 1, 0 ≦ a+b≦ 1) and formed with a double hetero junction structure in which an active layer is sandwiched between an n-type layer and a p-type layer.
